# FASCICULE DE BREVET EUROPEEN

(11) **EP 1 924 962 B1**
(45) Date de publication et mention de la délivrance du brevet: **20.06.2012**
(21) Numéro de dépôt: 06808123.1
(22) Date de dépôt: 13.09.2006
(51) Int. Cl.: B29C 45/14, G06K 19/077, B65D 1/30, H01L 21/673, G08B 13/24

(54) **DISPOSITIF D'ENCAPSULEMENT D'UNE PLURALITÉ D'ÉTIQUETTES D'IDENTIFICATION ÉLECTRONIQUES**
VORRICHTUNG ZUM EINKAPSELN EINER MEHRZAHL VON ELEKTRONISCHEN IDENTIFIZIERUNGSETIKETTEN
DEVICE FOR ENCAPSULATING A PLURALITY OF ELECTRONIC IDENTIFICATION TAGS

(30) Priorité: 13.09.2005 FR 0509337
(43) Date de publication de la demande: 28.05.2008
(73) Titulaire: Bara, Nicolas, 60240 La Villetertre (FR); Lo-Re, Bruno, 941000 Saint-Maur-des-Fossés (FR)
(72) Inventeur: Bara, Nicolas, 60240 La Villetertre (FR); Lo-Re, Bruno, 94100 Saint-Maur-des-Fossés (FR)
(74) Mandataire: Novagraaf Technologies
(86) Numéro de dépôt international: PCT/FR2006/002097
(87) Numéro de publication internationale: WO 2007/031644

(56) Documents cités:
- DE-U1- 9 000 670
- FR-A- 2 806 343
- US-A- 5 420 757
- US-A- 5 690 773
- US-A1- 2004 051 640

## Description

L'invention concerne un dispositif d'encapsulement d'une pluralité d'étiquettes d'identification électroniques destinées à être noyées dans un matériau plastique injecté.

Il est connu, par exemple du document WO-93/24381, de noyer une étiquette d'identification, telle qu'une puce RFID, dans un matériau plastique injecté formant les parois d'un container pour le transport de marchandises. La puce RFID permet l'identification à distance et sans contact du container. De plus, la puce peut également contenir des informations quant au contenu, à la provenance et la destination du container.

L'utilisation de puces RFID noyées dans un matériau plastique trouve de plus en plus d'applications dans différents domaines et pour réaliser différentes pièces.

Afin de permettre le noyage de l'étiquette d'identification, le document WO-93/24381 prévoit d'encapsuler l'étiquette dans un logement fermé hermétiquement et apte à supporter sans se dégrader l'injection du matériau plastique à haute température. Le logement est placé dans un moule et le matériau plastique est injecté autour du logement. On assure ainsi que l'étiquette est noyée dans le matériau et n'est pas détériorée par l'injection du matériau plastique.

Cependant, un tel procédé est peu facile à mettre en oeuvre du point de vue industriel. En effet, on prévoit un logement indépendant par étiquette d'identification, or ces étiquettes peuvent présenter une taille très réduite, par exemple 1 mm par 1 mm, il en résulte des difficultés pour placer une étiquette dans un logement. De plus, il faut prévoir une manoeuvre de mise dans le moule d'un logement pour chaque pièce que l'on veut réaliser, il n'est pas possible de placer plusieurs logements simultanément dans plusieurs moules. Pour certaines applications, on souhaite également placer plusieurs étiquettes dans une pièce injectée, le même problème se pose alors, il n'est pas possible de placer ces étiquettes simultanément dans le moule permettant de réaliser la pièce.

D'autre part, le logement ne dispose pas de moyens de maintien dans le moule ni de moyens de maintien de sa position par rapport à un autre logement Or, il est important de pouvoir placer l'étiquette électronique à un endroit précis de la pièce et selon une orientation particulière (par exemple, selon la direction d'émission de l'antenne). De plus, l'absence de moyens de maintien oblige à mener des opérations de positionnement longues et fastidieuses qui provoquent des temps d'ouverture du moule importants et peu compatibles avec les cadences de production industrielles.

Le US 2004 /051640 A1 décrit un dispositif d'encapsulement d'une pluralité d'étiquettes d'identification électroniques destinées à être noyées dans un matériau plastique injecté comprenant une pluralité de logements de réception d'une étiquette d'identification lesdits logements étant fermés hermétiquement et une pluralité de ponts de matière reliant chacun au moins deux logements consécutifs, lesdits ponts de matière étant agencés de sorte que les logements soient solidaires les uns des autres, selon le préambule de la revendication 1.

L'invention, vise à pallier ces inconvénients en proposant un dispositif d'encapsulement d'une pluralité d'étiquettes d'identification électroniques destinées à être noyées dans un matériau plastique injecté permettant de positionner avec précision l'ensemble des étiquettes les unes par rapport aux autres et par rapport à la pièce injectée autour des étiquettes. De plus, l'invention permet de nombreuses simplifications de l'encapsulement et de la disposition des étiquettes dans un moule facilitant la mise en oeuvre industrielle de l'intégration d'étiquettes dans une pièce injectée quelle que soit la taille et le nombre d'étiquettes.

A cet effet, l'invention concerne un dispositif d'encapsulement d'une pluralité d'étiquettes d'identification électroniques destinées à être noyées dans un matériau plastique injecté, ledit dispositif comprenant une pluralité de logements de réception d'une étiquette d'identification, lesdits logements étant fermés hermétiquement lorsqu'ils reçoivent une étiquette d'identification, ledit dispositif comprenant en outre une pluralité de ponts de matière reliant chacun au moins deux logements consécutifs, lesdits ponts de matière étant agencés de sorte que les logements forment une matrice, les logements étant solidaires les uns des autres.

L'ensemble des logements formant une matrice, il est aisé de disposer plusieurs étiquettes dans le dispositif en une seule étape au moyen d'un robot. De plus, la disposition de la matrice dans un moule ou dans plusieurs moules disposés les uns à côté des autres peut également être réalisée en une seule étape en maîtrisant de façon précise le positionnement et l'orientation des étiquettes d'identification. Le temps d'ouverture des moules est réduit et les cadences de production peuvent être augmentées.

Selon diverses réalisations, la matrice de logements peut être sensiblement plane ou le dispositif peut être tridimensionnel et comprendre une pluralité de matrices de logements sensiblement planes, lesdites matrices étant associés les unes aux autres par au moins un pont de matière.

La matrice de logements peut présenter différentes formes adaptées à son intégration au sein d'une ou plusieurs pièces.

On peut ainsi produire les matrices de façon standard de sorte à permettre de mouler des pièces différentes autour d'une même matrice et d'adapter une matrice à différentes formes de moule.

D'autres aspects et avantages de l'invention apparaîtront au cours de la description qui suit, faite en référence aux figures annexées.

La figure 1 est une représentation schématique en perspective d'un dispositif d'encapsulement ouvert et d'une étiquette d'identification électronique destinée à être disposée dans ledit dispositif.

La figure 2 est une représentation schématique en perspective du dispositif de la figure 1 fermé.

Les figures 3a et 3b sont des représentations schématiques en perspective de variantes de formes de dispositifs d'encapsulement selon l'invention.

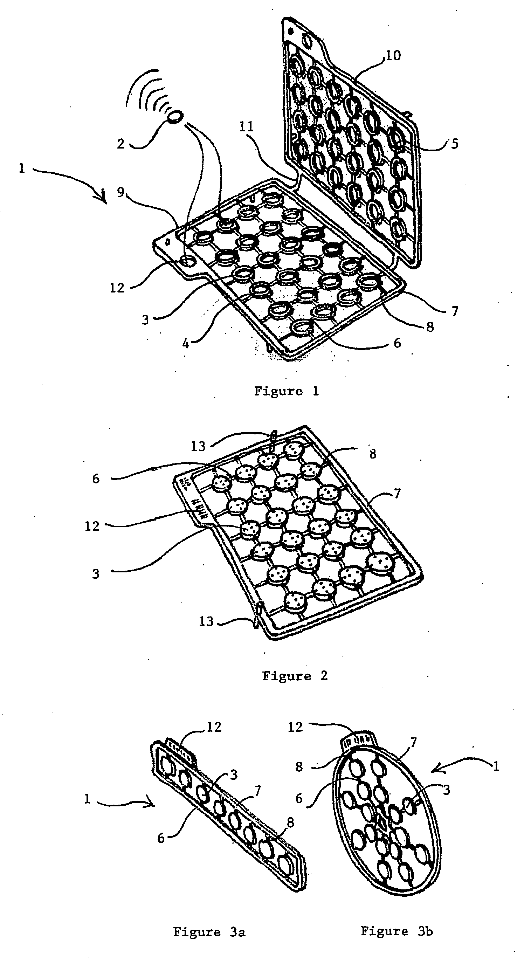

En référence aux figures 1 et 2, on décrit un dispositif d'encapsulement 1 d'une pluralité d'étiquettes d'identification électroniques 2, telles que des puces RFID munies de leur(s) événtuelle(s) antenne(s). Un tel dispositif 1 est destiné à être noyé dans un matériau plastique injecté, c'est-à-dire qu'il est destiné à être disposé dans un moule dans lequel une pièce réalisée en matériau plastique est injectée autour du dispositif 1. Une telle pièce peut par exemple être un container, l'étiquette permettant par exemple de connaître, à distance, le contenu, la provenance et la destination du container. D'autres pièces peuvent également être réalisées, telles que des dispositifs de prélèvement d'échantillons et toute autre pièce dont l'identification par une ou plusieurs étiquettes électroniques est souhaitable.

Le dispositif 1 comprend une pluralité de logements 3 de réception d'une étiquette d'identification 2. Chaque logement 3 est hermétiquement fermé, une fois qu'il a reçu une étiquette d'identification 2. À cet effet, chaque logement 3 comprend une base de réception 4 d'une étiquette 2 et un couvercle 5 apte à fermer hermétiquement la base 4, comme représenté sur la figure 1. Une pluralité de ponts de matière 6 relient chacun au moins deux logements 3 consécutifs. Les ponts de matière 6 sont agencés de sorte que les logements 3 forment une matrice et sont solidaires les uns des autres par l'intermédiaire de tous les ponts de matière 6. Par matrice, on entend que les logements 3 sont liés les uns aux autres et que leur position les uns par rapport aux autres est connue par leur position dans la matrice.

Selon la réalisation représentée sur la figure 1, une pluralité de ponts de matière 6 relient chacun respectivement deux bases 4 consécutives et deux couvercles 5 consécutifs de sorte à former une matrice de bases de réception 4 et une matrice de couvercles 5 correspondante. Ces matrices sont associées l'une à l'autre de sorte à former la matrice de logements 3.

Le dispositif 1 peut être réalisé d'une seule pièce. À cet effet, au moins un cadre 7 peut entourer la matrice de logements 3. Le cadre 7 est associé à ladite matrice par au moins un pont de matière 8 reliant un logement 3 au cadre 7. Comme représenté sur la figure 1, le cadre 7 se compose d'un cadre 9 entourant la matrice de bases de réception 4 et d'un cadre 10 entourant la matrice de couvercles 5, les cadres 9 et 10 étant reliés par au moins une charnière 11 agencée pour permettre de refermer la matrice de couvercles 5 sur la matrice de bases de réception 4. Des moyens de fixation peuvent être prévus pour fixer le cadre 10 sur le cadre 9. Ces moyens de fixation sont par exemple prévus pour chaque logement 3 par emboîtement des couvercles 5 sur les bases 4.

Selon les réalisations représentées sur les figures, chaque logement 3 situé à la périphérie de la matrice est associé au cadre 7 par au moins un pont de matière 8.

La matrice peut présenter une forme quelconque, telle que représentée sur les figures. Selon les figures 1 et 2, elle est rectangulaire, selon la figure 3a, elle est linéaire et selon la figure 3b, elle est circulaire. Dans le cas d'une matrice rectangulaire, les logements 3 situés aux coins de la matrice peuvent être reliés au cadre 7 par deux ponts de matière 8, comme représenté sur les figures 1 et 2. Dans le cas, d'une matrice circulaire, on peut également envisager de réaliser des ponts de matière reliant deux logements 3 successifs le long du cercle extérieur sans cadre autour de ce cercle et obtenir un dispositif 1 ayant la forme d'un cercle. Selon ces réalisations, la matrice de logements 3 est sensiblement plane.

Selon une réalisation non représentée, le dispositif 1 est tridimensionnel et comprend une pluralité de matrices de logements 3 sensiblement planes parallèles les unes aux autres. Ces matrices sont associées les unes aux autres par au moins un pont de matière s'étendant dans un plan non parallèle aux plans dans lesquels s'étendent les matrices planes.

Le cadre 7 peut comprendre un moyen d'identification 12 de la matrice de logements 3 et chaque logement 3 peut comprendre un moyen d'identification de sa position dans la matrice de logements 3. Ainsi, chaque étiquette électronique 2 peut être repérée par la matrice à laquelle elle appartient et par sa position dans ladite matrice. Le moyen d'identification 12 est par exemple formé par un code barre gravé dans le matériau du cadre 7, comme représenté sur les figures 2 à 3b. Selon la réalisation représentée sur la figure 1, le cadre 7 comprend un logement de réception d'une étiquette d'identification électronique 2, ladite étiquette formant moyen d'identification 12 de la matrice de logements 3. Le moyen d'identification de la position d'un logement 3 dans la matrice de logements 3 est par exemple formé par un nombre gravé dans le couvercle 5 et/ou la base 4 du logement 3 ; ainsi chaque logement 3 est numéroté et peut être repéré par son numéro représentant sa position dans la matrice de logements 3.

Le dispositif 1 est prévu pour être disposé dans un ou plusieurs moules d'injection des pièces à réaliser. En effet, on peut prévoir de noyer plusieurs étiquettes 2 dans une pièce ou une étiquette par pièce au moyen du dispositif 1. On peut également prévoir de noyer plusieurs logements 3 du dispositif dans une pièce et plusieurs logements 3 de ce même dispositif dans une autre pièce. Plusieurs moules sont alors disposés les uns à côté des autres et le dispositif 1 est placé de la façon souhaitée dans ces moules. À cet effet, le dispositif 1 est pourvu de moyens de positionnement 13 dans un ou plusieurs moules d'injection de matière plastique. On évite ainsi, lorsque le ou les moules sont ouverts, des étapes fastidieuses de positionnement du dispositif 1 dans le(s) moule(s). Les moyens de positionnement 13 comprennent par exemple des saillies s'étendant à partir du cadre 7 et/ou à partir des logements 3, les saillies étant sensiblement perpendiculaires au plan dans lequel s'étend le cadre 7 et étant destinées à prendre appui contre les parois du moule, comme représenté sur la figure 2. Ainsi, en posant simplement le dispositif 1 dans le(s) moule(s), on s'assure qu'il est correctement placé. Les moyens de positionnement 13 peuvent être agencés pour orienter les logements 3 de façon satisfaisante de sorte que les étiquettes 2 soient orientées pour permettre la lecture de leur contenu à distance.

Les ponts de matière 6, 8 peuvent être sécables ou découpables de manière à pouvoir désolidariser les logements 3 les uns des autres. Ceci est particulièrement utile lorsqu'un dispositif 1 est utilisé pour réaliser plusieurs pièces simultanément. On peut ainsi séparer les logements 3 les uns des autres en coupant les ponts de matière 6, 8 les reliant entre eux ou au cadre 7.

Les dimensions et la forme des logements 3 peuvent être adaptés à toute forme et toute taille d'étiquettes électroniques 2 disponibles. Le dispositif 1 selon l'invention permet de produire des matrices de façon standard et adaptées pour un placement facile des étiquettes 2 à l'intérieur des logements 2 comme indiqué précédemment.

En outre, le dispositif 1 est réalisé en un matériau apte à préserver son intégrité lors de l'injection d'un matériau plastique autour du dispositif, notamment à haute température et à forte pression d'injection.

## Revendications

1. Dispositif d'encapsulement d'une pluralité d'étiquettes d'identification électroniques (2) destinées à être noyées dans un matériau plastique injecté, ledit dispositif comprenant une pluralité de logements de réception (3) d'une étiquette d'identification (2), lesdits logements étant fermés hermétiquement lorsqu'ils reçoivent une étiquette d'identification (2), ledit dispositif comprenant en outre une pluralité de ponts de matière (6) reliant chacun au moins deux logements (3) consécutifs, lesdits ponts de matière étant agencés de sorte que les logements (3) forment une matrice, les logements (3) étant solidaires les uns des autres **caractérisé en ce qu'**il comprend au moins un cadre (7) entourant la matrice de logements (3), ledit cadre (7) étant associé à ladite matrice par au moins un pont de matière (8) reliant un logement (3) audit cadre et étant pourvu d'un moyen d'identification (12) de la matrice de logements (3).

2. Dispositif d'encapsulement selon la revendication 1, **caractérisé en ce que** chaque logement (3) comprend une base de réception (4) d'une étiquette (2) et un couvercle (5) apte à fermer hermétiquement ladite base, le dispositif comprenant une pluralité de ponts de matière (6) reliant chacun respectivement deux bases (4) consécutives et deux couvercles (5) consécutifs de sorte à former une matrice de bases de réception (4) et une matrice de couvercles (5) correspondante, lesdites matrices étant associées l'une à l'autre de sorte à former la matrice de logements (3).

3. Dispositif d'encapsulement selon la revendication 1 ou 2, **caractérisé en ce que** chaque logement (3) situé à la périphérie de la matrice est associé au cadre (7) par au moins un pont de matière (8).

4. Dispositif d'encapsulement selon l'une des revendications 1 à 3, lorsqu'elle dépend de la revendication 2, **caractérisé en ce que** le cadre (7) entoure la matrice de bases de réception (4) et la matrice de couvercles (5) correspondante, le cadre (7) comprenant une charnière (11) agencée pour permettre de refermer la matrice de couvercles (5) sur la matrice de bases de réception (4).

5. Dispositif d'encapsulement selon l'une des revendication 1 à 4, **caractérisé en ce que** le cadre (7) comprend un logement de réception d'une étiquette d'identification électronique (2), ladite étiquette formant moyen d'identification (12) de la matrice de logements (3).

6. Dispositif d'encapsulement selon l'une quelconque des revendications 1 à 5 **caractérisé en ce que** le dispositif (1) est réalisé d'une seule pièce.

7. Dispositif d'encapsulement selon l'une quelconque des revendications 1 à 6 **caractérisé en ce que** la matrice de logements (3) est sensiblement plane.

8. Dispositif d'encapsulement selon l'une quelconque des revendications 1 à 7, **caractérisé en ce qu'**il est tridimensionnel, ledit dispositif comprenant une pluralité de matrices de logements (3) sensiblement planes, lesdites matrices étant associées les unes aux autres par au moins un pont de matière.

9. Dispositif d'encapsulement selon l'une quelconque des revendications 1 à 8, **caractérisé en ce qu'**il comprend des moyens de positionnement (13) dans un ou plusieurs moules d'injection de matière plastique.

10. Dispositif d'encapsulement selon l'une quelconque des revendications 1 à 9, **caractérisé en ce que** chaque logement (3) comprend un moyen d'identification de sa position dans la matrice de logements (3).

11. Dispositif d'encapsulement selon l'une quelconque des revendications 1 à 10, **caractérisé en ce que** la matrice de logements (3) présente une forme sensiblement rectangulaire.

12. Dispositif d'encapsulement selon l'une quelconque des revendications 1 à 10, **caractérisé en ce que** la matrice de logements (3) présente une forme sensiblement circulaire.

13. Dispositif d'encapsulement selon l'une quelconque des revendications 1 à 12, **caractérisé en ce que** les ponts de matière (6, 8) sont sécables ou découpables.

14. Dispositif d'encapsulement selon l'une quelconque des revendications 1 à 13 **caractérisé en ce qu'**il est réalisé en un matériau apte à préserver son intégrité lors de l'injection d'un matériau plastique autour dudit dispositif.

## Claims

1. Encapsulation device for a plurality of electronic identification tags (2) designed to be incorporated in a plastic injected material, said device comprising a plurality of reception housings (3) for an identification tag (2), said housings being hermetically closed upon receiving an identification tag (2), said device also comprising a plurality of material bridges (6) each connecting at least two consecutive housings, said material bridges being arranged in such a way that the housings (3) form a matrix, the housings (3) being integral with each other, **characterised in that** it comprises at least one frame (7) surrounding the matrix of housings (3), said frame (7) being connected to said matrix by at least one material bridge (8) connecting one housing (3) to said frame and being equipped with a means of identification (12) of the matrix of housings (3).

2. Encapsulation device according to claim 1, **characterised in that** each housing (3) comprises a receiver base (4) for a tag (2) and a cover (5) suitable for hermetically closing said base, the device comprising a plurality of material bridges (6) each one respectively connecting two consecutive bases (4) and two consecutive covers (5) in such a way that a matrix of receiver bases (4) and a matrix of covers (5) are formed, said matrices being connected to one another in such a way that a matrix of housings (3) is formed.

3. Encapsulation device according to claim 1 or 2, **characterised in that** each housing (3) situated on the periphery of the matrix is connected to the frame (7) by at least one material bridge (8).

4. Encapsulation device according to any one of claims 1 to 3, when dependant on claim 2, **characterised in that** the frame (7) surrounds the matrix of receiver bases (4) and the corresponding matrix of covers (5), the frame (7) comprising a hinge (11) placed in such a way that the matrix of covers (5) can be closed over the matrix of receiver bases (4).

5. Encapsulation device according to one of claims 1 to 4, **characterised in that** the frame (7) comprises a receiving housing for an electronic identification tag (2), said tag forming a means of identification (12) of the matrix of housings (3).

6. Encapsulation device according to any one of claims 1 to 5, **characterised in that** the device (1) functions as a single unit.

7. Encapsulation device according to any of claims 1 to 6, **characterised in that** the matrix of housings (3) is substantially flat.

8. Encapsulation device according to any one of claims 1 to 7, **characterised in that** it is three-dimensional, said device comprising a plurality of substantially flat matrices of housings (3), said matrices being connected to one another by at least one material bridge.

9. Encapsulation device according to any one of claims 1 to 8, **characterised in that** it comprises positioning means (13) in one or several injection moulds made from plastic.

10. Encapsulation device according to any one of claims 1 to 9, **characterised in that** each housing (3) comprises a means for identifying its position in the matrix of housings.

11. Encapsulation device according to any one of claims 1 to 10, **characterised in that** the matrix of housings (3) is substantially rectangular in shape.

12. Encapsulation device according to any one of claims 1 to 10, **characterised in that** the matrix of housings (3) is substantially circular in shape.

13. Encapsulation device according to any one of claims 1 to 12, **characterised in that** the bridges of material (6,8) can be divided or cut.

14. Encapsulation device according to any one of claims 1 to 13, **characterised in that** it is made from a material suitable for remaining intact after the injection of a plastic material around said device.

## Patentansprüche

1. Vorrichtung zum Einkapseln eine Mehrzahl von elektronischen Identifikationsetiketten (2) die dazu bestimmt sind, in ein Spritzguss-Kunststoffmaterial eingetaucht zu werden, wobei die Vorrichtung eine Mehrzahl von Empfangs-Aufnahmen (3) eines Identifikationsetiketts (2) umfasst, wobei die Aufnahmen hermetisch verschlossen werden, sobald sie ein Identifikationsetikett (2) empfangen, wobei die Vorrichtung ferner eine Mehrzahl von Materialbrücken (6) umfasst, die jeweils wenigstens zwei aufeinanderfolgende Aufnahmen (3) verbinden, wobei die Materialbrücken derart angeordnet sind, dass die Aufnahmen (3) eine Matrix bilden, wobei die Aufnahmen (3) fest miteinander verbunden sind, **dadurch gekennzeichnet, dass** diese wenigstens einen Rahmen (7) umfasst, der die Aufnahmematrix (3) umgibt, wobei der Rahmen (7) mit der Matrix durch wenigstens eine Materialbrücke (8) verbunden ist, welche eine Aufnahme (3) mit dem Rahmen verbindet, und mit einem Identifikationsmittel (12) für die Aufnahmematrix (3) versehen ist.

2. Vorrichtung zum Einkapseln nach Anspruch 1, **dadurch gekennzeichnet, dass** jede Aufnahme (3) aufweist eine Empfangsbasis (4) für ein Etikett (2) und einen Deckel (5), der so ausgebildet ist, dass dieser die Basis hermetisch verschließt, wobei die Vorrichtung eine Mehrzahl von Materialbrücken (6) umfasst, die jeweils zwei aufeinanderfolgende Basen (4) und zwei aufeinanderfolgende Deckel (5) so verbinden, dass eine Matrix der Empfangsbasen (4) und eine korrespondierende Deckelmatrix (5) gebildet wird, wobei die Matrizes einander so zugeordnet sind, dass sie die Aufnahmematrix (3) bilden.

3. Vorrichtung zum Einkapseln nach Anspruch 1 oder 2, **dadurch gekennzeichnet, dass** jede Aufnahme (3), die am Umfang der Matrix liegt, mit dem Rahmen (7) durch wenigstens eine Materialbrücke (8) verbunden ist.

4. Vorrichtung zum Einkapseln nach einem der Ansprüche 1 bis 3, wenn dieser von Anspruch 2 abhängig ist, **dadurch gekennzeichnet, dass** der Rahmen (7) die Matrix der Empfangsbasen (4) und die korrespondierende Deckelmatrix (5) umgibt, wobei der Rahmen (7) ein Scharnier (11) umfasst, das angeordnet ist, um ein Schließen der Deckelmatrix (5) auf der Matrix der Empfangsbasen (4) zu erlauben.

5. Vorrichtung zum Einkapseln nach einem Ansprüche 1 bis 4, **dadurch gekennzeichnet, dass** der Rahmen (7) eine Aufnahme zum Empfang eines elektronischen Identifikationsetiketts (2) umfasst, wobei das Etikett ein Identifikationsmittel (12) für die Aufnahmematrix (3) bildet.

6. Vorrichtung zum Einkapseln nach einem der Ansprüche 1 bis 5, **dadurch gekennzeichnet, dass** die Vorrichtung (1) einstückig ausgebildet ist.

7. Vorrichtung zum Einkapseln nach einem der Ansprüche 1 bis 6, **dadurch gekennzeichnet, dass** die Aufnahmematrix (3) im Wesentlichen plan ist.

8. Vorrichtung zum Einkapseln nach einem der Ansprüche 1 bis 7, **dadurch gekennzeichnet, dass** diese dreidimensional ist, wobei die Vorrichtung eine Mehrzahl von im Wesentlichen planen Aufnahmematrizes (3) umfasst, wobei die Matrizes untereinander durch wenigstens eine Materialbrücke verbunden sind.

9. Vorrichtung zum Einkapseln nach einem der Ansprüche 1 bis 8, **dadurch gekennzeichnet, dass** diese Positionierungsmittel (13) in einer oder in mehreren Kunststoffmaterial-Spritzgussformen umfasst.

10. Vorrichtung zum Einkapseln nach einem der Ansprüche 1 bis 9, **dadurch gekennzeichnet, dass** jede Aufnahme (3) ein Identifikationsmittel für seine Position in der Aufnahmematrix (3) umfasst.

11. Vorrichtung zum Einkapseln nach einem der Ansprüche 1 bis 10, **dadurch gekennzeichnet, dass** die Aufnahmematrix (3) eine im Wesentlichen rechtwinklige Form aufweist.

12. Vorrichtung zum Einkapseln nach einem der Ansprüche 1 bis 10, **dadurch gekennzeichnet, dass** die Aufnahmematrix (3) eine im Wesentlichen kreisförmige Form aufweist.

13. Vorrichtung zum Einkapseln nach einem der Ansprüche 1 bis 12, **dadurch gekennzeichnet, dass** die Materialbrücken (6, 8) teilbar oder segmentierbar sind.

14. Vorrichtung zum Einkapseln nach einem der Ansprüche 1 bis 13, **dadurch gekennzeichnet, dass** diese aus einem Material hergestellt wird, das so ausgebildet ist, dass dieses bei dem Einspritzen eines Kunststoffmaterials um die Vorrichtung herum seine Integrität bewahrt.
